# EUROPEAN PATENT APPLICATION

(11) **EP 2 563 107 A1**
(43) Date of publication of application: **27.02.2013**
(21) Application number: 10850193.3
(22) Date of filing: 27.12.2010
(51) Int. Cl.: H05K 5/02, B01D 71/36, H05K 5/06

(54) **VENTILATION MEMBER AND VENTILATION CASE EQUIPPED WITH SAME**

(30) Priority: 23.04.2010 JP 2010100073
(71) Applicant: NITTO DENKO CORPORATION, Ibaraki-shi, Osaka 567-8680 (JP)
(72) Inventor: SUZUKI, Masatoshi, Ibaraki-shi Osaka 567-8680 (JP); FURUYAMA, Satoru, Ibaraki-shi Osaka 567-8680 (JP); TEZUKA, Teppei, Ibaraki-shi Osaka 567-8680 (JP)
(74) Representative: Intès, Didier Gérard André
(86) International application number: PCT/JP2010/007576
(87) International publication number: WO 2011/132247

(57) **Abstract**

A vented housing having high flame resistance, water resistance and insulation is provided. Furthermore, a ventilation member to be included in such a vented housing is provided. The ventilation member according to the present, invention is a ventilation member to be fixed to a housing so as to cover an opening of the housing. The ventilation member includes: a support body in which a through hole is formed; and a gas permeable membrane that covers the through hole and allows a gas passing through the opening to permeate through the gas permeable membrane. The support body contains a polyphenylene ether resin or a polyphenylene oxide resin, and the gas permeable membrane is composed only of a porous polytetrafluoroethylene membrane.

## Description

### TECHNICAL FIELD

The present invention relates to a vented housing suitable for terminal boxes, and further relates to a ventilation member to be included in the vented housing.

### BACKGROUND ART

In many cases, electrical appliances, such as a solar cell, used outdoor require a housing, such as a terminal box, in which electrical components are disposed. For example, a by-pass diode is accommodated in a terminal box for a solar cell. When water, such as rain water, and dust enter into such a terminal box, a short circuit and an ignition may occur. As a method to prevent this, there can be mentioned a method in which the electrical components are encapsulated with a potting material so as to be presented from contacting water and dust. As another method, there can be mentioned a method in which all opening of the housing is closed with a plug or the like to isolate the inside of the housing from the outside so that the electrical components are presented from contacting water and dust. In the case of closing the opening of the housing, when the housing is sealed completely, the pressure inside the housing is increased because of the rise in temperature inside the housing due to the operations of the electrical components. The increase in the pressure inside the housing applies a force to an inner surface of the housing and causes a problem such that the plug closing the opening comes off. Thus, there is used a method in which the opening of the housing is covered with a ventilation member that is breathable and does not allow the dust and water to pass therethrough. Examples of the ventilation member to be fixed to a housing having an opening include the ventilation members disclose in Patent Literatures 1 and 2. These ventilation members each have a support body with a size capable of covering the opening of the housing, and a gas permeable membrane that covers a through hole formed in the support body. The ventilation members each are fixed to the housing so that the gas permeable membrane is located on the opening.

### CITATION LIST

### Patent Literature

PTL 1: JP 2003-318557 A
PAL 2: JP 2008-237949 A

### SUMMARY OF INVENTION

### Technical Problem

A terminal box placed in a house, typified by a terminal box for a solar cell, is required to have flame resistance. Thus, as a ventilation member used for a terminal box for a solar cell, a wintered metal filter with high flame resistance its used in many cases. However, the sintered metal filter has a problem of having low water resistance and liquid repellency. Furthermore, since the sintered metal filter is not an insulating material, it needs to be disposed at a specified distance (insulation distance) away from the electrical components disposed in the terminal box. This rises a problem in that the degree of freedom in designing the terminal box for a solar cell is lowered and the terminal box its increased in size.

The present invention has been accomplished in view of the foregoing circumstance. The present invention is intended to provide a vented housing with high flame resistance, water resistance and insulation, and further to provide a ventilation member to be included in the vented housing.

### Solution to Problem

The ventilation member of the present invention is a ventilation member to be fixed to a housing so as to cover an opening of the housing, including: a support body in which a through hole is formed; and a gas permeable membrane that covers the through hole and allows a gas passing through the opening to permeate through the gas permeable membrane.
The support body contains a polyphenylene ether resin or a polyphenylene oxide resin. The permeable membrane is composed only of a porous polytetrafluoroethylene membrane.

A vented housing of the present invention includes: the ventilation member of the present invention; and a housing having an opening. The housing contains a polyphenylene ether resin or a polyphenylene oxide resin. The ventilation member is fixed to the housing so as to cover the opening.

### Advantageous Effects of Invention

In the ventilation member of the present invention, the support body contains a polyphenylene ether resin or a polyphenylene oxide resin. The gas permeable membrane is composed only of a polytetrafluoroethylene porous membrane, and no reinforcing material is used. Since the polyphenylene ether resin, the polyphenylene oxide resin, and the porous polytetrafluoroethylene membrane each have high flame resistance, water resistance and insulation, the ventilation member also has high flame resistance, water resistance and insulation. Therefore, the ventilation member according to the present invention is suitable as a component for a vented housing in which members, such as electrical components, that are unfavorable to be in contact with water and dust are disposed. Moreover, since the vented housing according to the present invention has flame resistance, water resistance and insulation and can be designed without taking into consideration the arrangement of the ventilation member and the electrical components, the degree of freedom in designing the vented housing is high and the vented housing can be reduced in size.

### BRIEF DESCRIPTION OF THE DRAWINGS

FIG. 1 is a perspective view showing one embodiment of the ventilation member according to the present invention.
FIG. 2 is a cross-sectional view of FIG. 1, taken along the line II-II.
FIG. 3 is a cross-sectional view showing one embodiment of the vented housing according to the present invention.
FIG. 4 is an enlarged cross-sectional view showing an example of fixing between the ventilation member and the housing according to the present invention.
FIG. 5 is an enlarged cross-sectional view showing another example of fixing between the ventilation member and the housing according to the present invention.
FIG. 6 is an exploded perspective view showing another embodiment of the ventilation member according to the present invention.
FIG. 7 is a cross-sectional view showing the configuration of a vented housing of Comparative Example 2.

### DESCRIPTION OF EMBODIMENTS

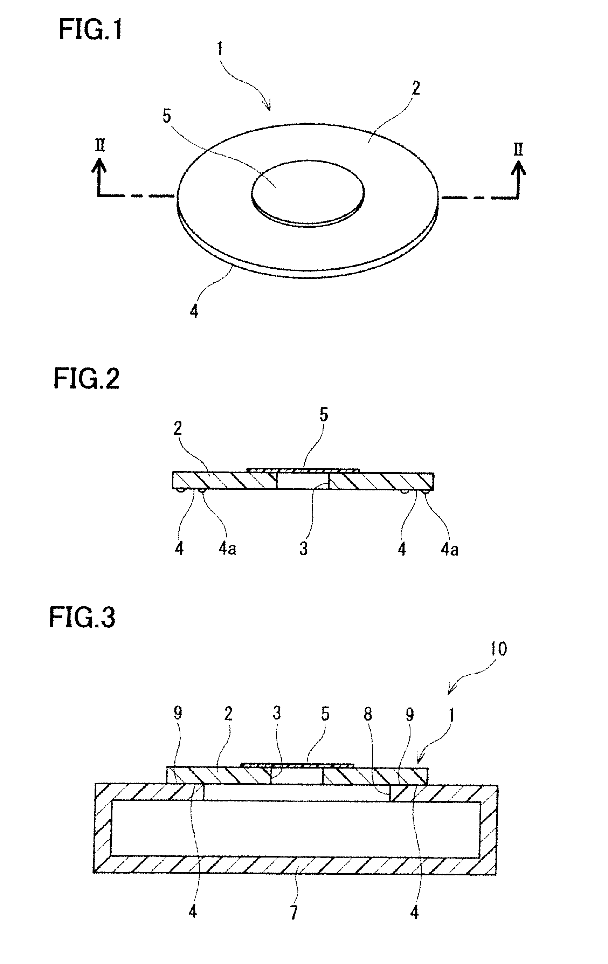

FIG. 1 is a perspective view showing one embodiment of the ventilation member according to the present invention. FIG. 2 is a cross-sectional view of FIG. 1, taken along the line II-II. FIG. 3 is a cross-sectional view showing one embodiment of the vented housing according to the present invention. The configurations of the ventilation member and the vented housing according to the present invention are described with reference to FIG. 1, FIG. 2 and FIG. 3. A ventilation member I includes a support body 2 and a gas permeable membrane 5 that does not allow water and dust but allows a gas to permeate therethrough. The support body 2 is a flat plate with a circular outer periphery. A circular through hole 3 is formed at the center of the support body 2. The gas permeable membrane 5 is fixed to one main surface of the support body 2 so as to cover the through hole 3. A vented housing 10 includes a housing 7 in which an opening 8 is formed, and the ventilation member 1. The ventilation member I is fixed to the housing 7 so as two cover the opening 8. The gas permeable membrane 5 is located on the opening 8.

The gas permeable membrane 5 is composed only of a porous polytetrafluoroethylene (hereinafter referred to as "PTFE") membrane, and includes no reinforcing material. The porous PTFE membrane can maintain breathability with a small area, and is highly capable of blocking water and dust. Usually, the porous PTFE membrane is laminated on a reinforcing material in order to complement the strength in applications such as an air filter. As the reinforcing material, a woven fabric, a nonwoven fabric, a net, etc. made of a thermoplastic resin, such as polyethylene, polypropylene and polyethylene terephthalate, are commonly used. However, use of the reinforcing material lowers the flame resistance and insulation of the ventilation member. The gas permeable membrane 5 composed only of a porous PTFE membrane has high flame resistance, insulation, water resistance and liquid repellency.

The gas permeable membrane 5 is welded to one main surface of the support body 2 so as to close the through hole 3 of the support body 2. Since the gas permeable membrane 5 is fixed to the support body 2 by welding, separation, floating, etc. of the gas permeable membrane 5 hardly occur. The manner of welding is not particularly limited, and heat welding, ultrasonic welding, impulse welding, etc can be performed. Considering production efficiency and initial investment, heat welding is preferred.

In order to increase water repellency and oil repellency, the gas permeable membrane 5 may be created with a liquid-repellent treatment. In order to allow the gas permeable membrane 5 to have a higher liquid repellency than that of the porous PTFE membrane, a liquid-repellent agent composed of a compound in which a hydrocarbon group saturated with fluorine (perfluoroalkyl group) is contained in a side chain and a main chain is an acrylic chain, a methacrylic chain, a silicone chain or the like can be applied to the gas permeable membrane 5. Examples of the method for applying the liquid-repellent agent to the gas permeable membrane 5 include kiss coating, gravure coating, spray coating, and immersion. In order to prevent the entry of water from the outside to the inside of the vented housing 10, the gas permeable membrane 5 preferably is disposed so that a surface thereof with high liquid repellency faces toward the outside (the side opposite to the housing 7) in the state in which the gas permeable membrane 5 is mounted on the vented housing 10.

The porous PTFE membrane, which is the gas permeable membrane 5, can be produced in accordance with a known method. For example, it can be produced by a method in which a paste extrudate composed of PTFE fine powder and a lubricant, such as kerosene, is stretched and then sintered. Also, the porous PTFE membrane is available as a commercial product.

Preferably, the gas permeable membrane 5 has a weight per unit area of 20 g/m² or more. Thereby, the water resistance of the gas permeable membrane 5 is enhanced. For example, in the case where the vented housing 10 is used outdoors, even when the gas permeable membrane 5 is splashed with water because of rain, etc., it is possible to prevent the water from entering into the vented housing 10.

In order to increase the air permeance, it is favorable for the gas permeable membrane 5 to have a smaller thickness, but an excessively small thickness lowers its strength. Preferably, the gas permeable membrane 5 has a thickness of 0.1 mm to 0.5 mm.

Preferably, the breakdown voltage of the gas permeable membrane 5 is 2000 V or higher in accordance with JIS C2110. Thereby, the insulation of the gas permeable membrane 5 is enhanced. For example, electric leakage, etc. hardly occur even when the gas permeable membrane 5 is disposed in the vicinity of the electrical components, such as a by-pass diode, placed in the housing 7. The method for measuring the breakdown voltage is described briefly below. Two spherical electrodes each having a diameter of 12.5 mm are disposed so as to face each other in the thickness direction oaf the gas permeable membrane, and the gas permeable membrane is sandwiched between the electrodes. The voltage between the electrodes is increased by the electrodes at a rate of 1 kV/second in the state in which a load of about 500 g is being applied, by the electrodes, to the gas permeable membrane in the thickness direction of the gas permeable membrane. The voltage at the time when an electric breakdown occurs is measured, and this value is defined as the breakdown voltage.

Preferably, the gas permeable membrane 5 has an air permeance of 40 seconds/100 ml or less in terms of Gurley number in accordance with JIS P8117. Thereby, the breathability of the gas permeable membrane 5 is enhanced.

Preferably, the gas permeable membrane 5 has a water pressure resistance of 0.05 MPa or higher in accordance with JIS L1092. Thereby, the water resistance of the gas permeable membrane 5 is enhanced. For example, in the case where the vented housing 10 is used outdoors, even when the gas permeable membrane 5 is splashed with water because of rain, etc., it is possible to prevent the water from entering into the vented housing 10.

The support body 2 contains a polyphenylene ether resin (hereinafter preferred to as "PPE") or a polyphenylene oxide resin (hereinafter referred to as "PPO"). Preferably, the support body 2 is composed of PIPE or PPO. Since each of the PPE and PPO has high flame resistance, insulation and water resistance, the support body 2 containing PPE or PPO also has high flame resistance, insulation and water resistance.

In the case where the support body 2 is fixed to the housing 7 by welding, it is preferable that the support body 2 and the housing 7 have high compatibility therebetween. Thereby, the fixing strength between the support body 2 and the housing 7 is enhanced. Therefore, a main component of the support body 2 preferably is the same as a main component of the housing 7, more preferably components of the support body 2 other than its main component are the same as components of the housing 7 other than its main component, and further preferably the ratio of each component of the support body 2 is the same as the ratio of each component of the housing 7. The main component refers to a component with a content higher than 50%.

The support body 2 has a fixing face 4 to be fixed to the housing 7. The fixing face 4 is, out of the main surfaces of the support body 2, the surface on the side opposite to the surface on which the gas permeable membrane 5 is disposed. A protruding welding rib 4a is disposed on the fixing face 4. Preferably, the welding rib 4a contains PPE or PPO, and more preferably the welding rib 4a is composed of PPE or PPO. The welding rib 4a is melted and spread between the fixing face 4 and an adherend face 9 of the housing 7 and solidified in this state. Thereby, welding is achieved. When the fixing face 4 is composed of a weldable material, the welding rib 4a does not need to be provided. Preferably, the fixing face 4 contains PPE or PPO, and more preferably the fixing face 4 is composed of PPE or PPO.

The support body 2 can be configured to have a larger outer diameter than the diameter of the opening 8 formed in the housing 7, and has a shape that allows the support body 2 to be fixed to the housing 7 so as to cover the opening 8. Preferably, the support body 2 is a flat plate. In the housing 7, the adhered face 9 two which the support body 2 is fixed is usually a flat face. Thus, when the support body 2 is a flat plate, it is easy for the fixing face 4 to be contacted closely to the adherend face 9, and the support body 2 is fixed to the housing 7 more stably. Furthermore, the gas permeable membrane 5 can be welded to the support body 2 easily.

The size of the through hole 3 can be determined as appropriate taking into consideration the application of the vented housing 10 and the gas permeation quantity of the gas permeable membrane 5.

Preferably, the support body 2 has a thickness of about 2.5 mm or more. Thereby, the flame resistance of the support body 2 is enhanced. Preferably, the support body 2 has a thickness that allows the support body 2 to have a flame resistance classified as 5 VA or so in accordance with UL94 under UL (Underwriters Laboratories Inc.) standard when measured on a specimen of the material used for the support body 2. 5 VA is a criterion for indicating flame resistance. In order to satisfy the 5 VA criterion, the requirements of both of the flammability test using a strip-shape specimen and the flammability test using a flat plate specimen described below need to be satisfied. Specifically, when the strip-shape specimen held vertically is exposed to a 125 mm flame for 5 seconds and this is repeated 5 times, the burning time thereafter including flaming burning and non-flaming burning needs to be 60 seconds or less, and at that time there needs to be no drips that ignite cotton placed below the strip-shape specimen. Furthermore, when the flat plate specimen held horizontally is exposed to a 125 mm flame underneath for 5 seconds and this is repeated 5 times, the flat plate specimen thereafter needs to have no holes.

The method for forming the support body 2 is not particularly limited. It can be formed by injection molding and cutting, for example.

Preferably, the housing 7 contains PPE or PPO, and more preferably the housing 7 is composed of PPE or PPO. This allows the housing 7 to have high flame resistance, insulation and water resistance.

The vented housing 10 has a configuration in which the ventilation member 1 is fixed to the housing 7 so as to cover the opening 8 of the housing 7 from the outside.

Preferably, the ventilation member 1 is fixed to the housing 7 by welding. This makes the fixing easy. Considering the fact that the adherend face 9 of the housing 7 usually has no projections and depressions and is flat, the fixing face 4 of the support, body 2 also can be flat. This allows the fixing face 4 two be in close contact with the adherend face 9, making it possible two achieve more stable welding. The welding manner is not particularly limited, and heat welding, ultrasonic welding or impulse welding may be used. Considering the production efficiency and the initial investment, it is preferable to perform heat welding. When the welding rib 4a is formed on the fixing face 4, the welding rib 4a is melted and spread between the fixing face 4 and the adherend face 9 and solidified in this state. Thereby, the air lightness of the vented housing 10 is enhanced.

Various problems arise when the gas permeable membrane is welded directly to the housing without using the support, body. For example, there occur problem such that: the gas permeable membrane is not welded uniformly; even though the gas permeable membrane, is wielded uniformly, the overall welding is insufficient; and the gas permeable membrane is damaged during the welding work. In the present invention, since the support body 2 with the gas permeable membrane 5 welded thereto is welded to the housing 7, these problem hardly occur.

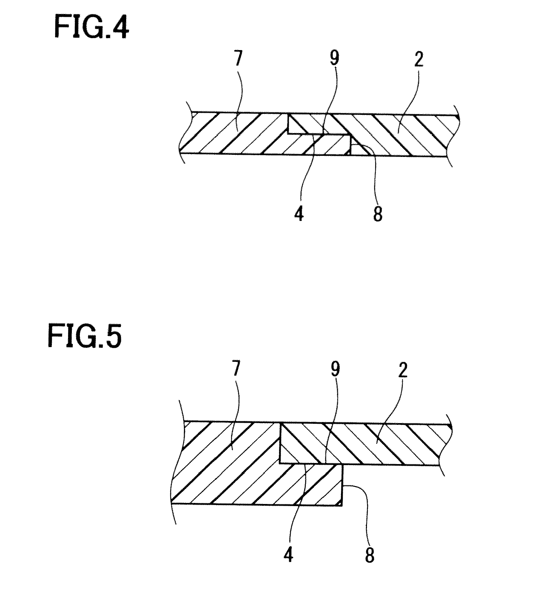

As an embodiment, of fixing of the ventilation member 1 to the housing 7, a configuration such as the ones shown in FIG. 4 and FIG. 5 may ) be used. Fig. 4 and FIG. 5 are enlarged cross-sectional views showing respectively an example of fixing between the ventilation member and the housing according to the present invention and another Example thereof. They each show an enlarged cross-sectional shape around the fixing face and the adherend face. In the example shown in FIG. 4, an outer peripheral part of the support body 2 and the opening 8 each have a stepped portion and these steps are fitted to each other. In the example shown in FIG. 5, only the opening 8 has a stepped portion and the support body 2 is fitted to the stepped portion of the opening 8. A configuration as shown in FIG. 4 or FIG. 5 allows no level difference to be caused on a surface of the vented housing 10, at the interface between the housing 7 and the support body 2. Accordingly, the surface of the vented housing 10 can be free from the level difference except for a portion to which the gas permeable membrane 5 is attached. Thereby, it is possible to save a space to attach the vented housing 10. Moreover, since the ventilation member 1 is fitted to the housing 7 and fixed thereto, the ventilation member 1 does not move at the time when the ventilation member 1 is wielded to the housing 7, and the welding can be performed easily.

while the method for fixing the ventilation member 1 to the housing 7 by welding is described above, the support body 2 may be fixed to the housing 7 by a method other than welding. For example, the housing 7 and the support body 2 may be moulded integrally with each other by injection molding or the like.

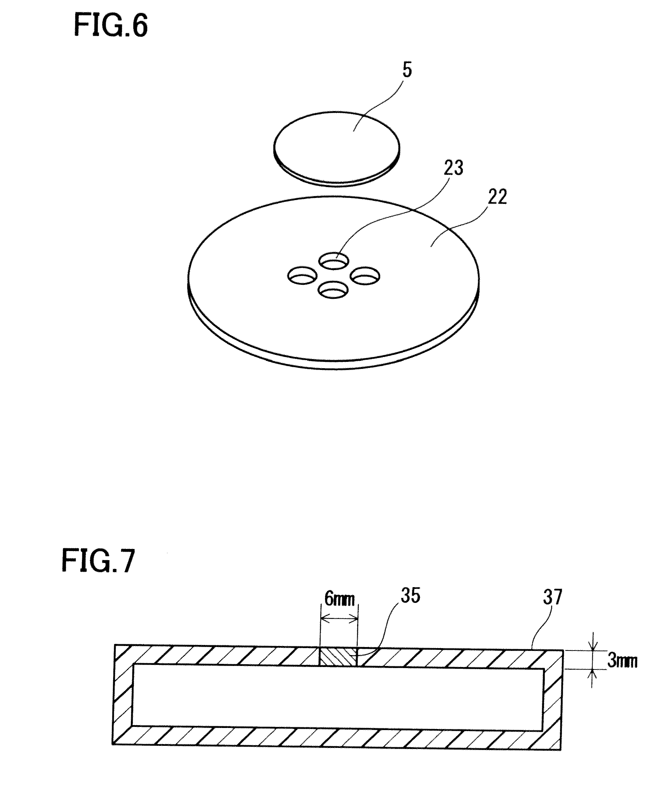

while Fig. 2 shows an embodiment, of the ventilation member 1 in which the number of the through hole 3 is one, a plurality of through holes may be formed as shown in FIG. 6. FIG. 6 is an exploded perspective view showing another embodiment of the ventilation member according to the present invention. As shown in Fig. 6, four circular through holes 23 are formed so as to surround the center of a support body 22 having a circular outer periphery. The number of the through holes 23 is not limited to four. The support body 22 has the same configuration that of the support body 2 in FIG. 2, except that it has the plurality of the through holes 23. The gas permeable membrane 5 is fixed to one main surface of the support, body 22 by welding so as to cover all of the through holes 23 of the support, body 22, so that a ventilation member is fabricated. Like the ventilation member 1, this ventilation member is fixed to the housing 7 so as to form the vented housing 10. This allows the gas permeable membrane 5 to be wielded to the support body 22, at a peripheral part and a portion corresponding to an area surrounding the through holes 23. Thereby, the fixing strength is increased and the gas permeable membrane, 5 is hardly damaged. Although the size of each through hole 23 is smaller than that in the embodiment where the number of the through hole is one, the multiple through holes 23 make it possible to obtain a desired gas permeation quantity.

### Examples

Hereinafter, the present invention is described in further detail with reference to examples.

### (Example 1)

A support body as shown in FIGs. 1 and 2 was produced by injection molding. As the material resin, PPE (Iupiace LN40 produced by Mitsubishi Gas Chemical Co., Inc.) was used. The support, body was a flat plate with a circular outer periphery, and had a circular through hole formed at, its center. The support body had a thickness of 2.5 mm and an outer diameter of 18 mm. The through hole had an inner diameter of 6 mm. As the gas permeable membrane, a porous PTFE membrane, (S-NTF8031 produced by Nitto Denko Corp.) with a diameter of 10 mm was used. The gas permeable membrane was welded to the support body at 3 MPa for 3 seconds by using a horn (inner periphery φ7 mm x outer periphery φ8 mm) at a temperature of 290°C. Thereby, a ventilation member was obtained. A housing was produced by injection molding using PPE (Iupiace LN40 produced by Mitsubishi Gas Chemical Co., Inc.) in the same manner as the support body was produced.
A wall of the housing had a thickness of 3 mm. The opening of the housing had an inner diameter of 12 mm.

The ventilation member was disposed so as to cover the opening of the housing, and the ventilation member was welded to the housing by using an ultrasonic welding machine (manufactured by Ultrasonic Engineering Co., Ltd.) under the conditions that the frequency was 30 kHz and the pressure was 30 MPa. Thereby, a vented housing as shown in Fig. 3 was obtained.

### (Example 2)

A porous PTFE membrane (S-NTF810,A with a diameter or 10 mm, produced by Nitto Denko Corp.) having a weight per unit area and a thickness that where different from those of the porous PTFE membrane used in Example 1 was used as the gas permeable membrane. A vented housing was obtained by the same method using the sane material as in Example 1 except for this.

### (Comparative Example 1)

A membrane (S-NTF1033-K02 with a diameter of 10 mm, produced by Nitto Denko Corp.) with a configuration in which a porous PTFE membrane and a reinforcing material (polyolefin nonwoven fabric) were laminated together was used as the gas permeable membrane. The gas permeable membrane had a thickness of 0.15 mm. The porous PTFE membrane, had a thickness of 10 µm. The reinforcing material had a thickness of 140 µm. A vented housing was obtained by the same method using the same material as in Example 1 except for these.

### (Comparative Example 2)

A sintered metal filter that was a sintered metal body made of a Cu-Sn-Zn alloy was used as a gas permeable part. The gas permeable part had the shape of a circular flat plate with an outer diameter of 6 mm. PPE (Iupiace LN40 produced by Mitsubishi Gas Chemical Co., Inc.) was poured into a mold in which the sintered metal filter that was the gas permeable part had been placed in advance. A vented housing in which the sintered metal filter and the housing were molded integrally with each other was produced by injection molding. FIG. 7 is a cross-sectional view showing the configuration of the vented housing of Comparative Example 2. A wall of a housing 37 and a gas permeable part 35 that was the sintered metal filter each had a thickness of 3 mm.

### Each vented housing obtained was subject, to the following tests.

Table 1 shows the test results. Only the water resistance test on housing was conducted on the vented housing, and the other tests were conducted on the gas permeable membrane (part).

### resistance test on housing]

The vented housing with Water Feeling Paste (produced by Sankyo Chemical Industry Co., Ltd.) applied to inner side thereof was sunk in a tank containing 1 m depth of water and left for 30 minutes, and then pulled out therefrom to determine whether water had entered into the vented housing. The determination was made by checking visually the change in color of the Water Feeling Paste. The Water Feeling Paste is usually blue but turns to red when it contacts water. This makers it possible to check visually the entry of water into the vented housing.

### [Water pressure resistance test]

The gas permeable membrane (part) was measured for water pressure resistance at a pressure increasing rate of 100 kPa/minute in accordance with JIS L1092.

### [Air permeance test]

The gas permeable membrane (part) was measured for air permeance by measuring the time for 100 cm³ of air to take, at 1.23 KPa, to pass through the specimen with a gas permeable area of 642 mm² in accordance with JIS P8117 (Gurley method).

### breakdown voltage test]

The gas permeable membrane (part) was sandwiched, along its thickness direction, between two spherical electrodes each having a diameter of 12.5 mm in accordance with JIS C2110. The electrodes applied a load of about 500 g to the gas permeable membrane and increased the voltage between the electrodes at a rate of 1 kV/second. The voltage at the time when an electric breakdown occurred was measured.

### [Flammability test]

The gas permeable membrane (part) was measured for flammability in accordance with UL94V vertical flammability test under UL specifications. The UL94V vertical flammability test under UL specifications was conducted as fellows. Specimens (five specimens) were set vertically with a clamp. The specimens were exposed to a 20 mm flame for 10 seconds and this was repeated 2 times. Then, the flammability was determined by checking the burning behavior of the specimens. V0, V1 and V2 were used as the criteria under which the flammability was determined. In order to satisfy the V0 criterion, it was necessary that: the flaming burning period of each specimen after each exposure to the flame was 10 seconds or less; the total of the flaming burning periods of the five specimens after the first exposure and the flaming burning periods of the five specimens after the second exposure was 50 seconds or less; the burning period including flaming burning and non-flaming burning of each specimen after the second exposure to the flame was 30 seconds or less; none of the specimens was burned out; and there were no drips igniting the cotton placed below each specimen. In order to satisfy the V1 criterion, it was necessary that: the flaming burning period of each specimen after each exposure to the flame was 30 seconds or less; the total of the flaming burning periods of the five specimens after the first exposure and the flaming burning periods of the five specimens after the second exposure was 250 seconds or less; the burning period including flaming burning and non-flaming burning of each specimen after the second exposure to the flame was 60 seconds or less; none of the specimens was burned out; and there were no drips igniting the cotton placed below each specimen. In order to satisfy the V2 criterion, it was necessary that: the flaming burning period of each specimen after each exposure to the flame was 30 seconds or less; the total of the flaming burning periods of the five specimens after the first exposure and the flaming burning periods of the five specimens after the second exposure was 250 seconds or less; the burning period including flaming burning and non-flaming burning of each specimen after the second exposure to the flame was 60 seconds or less; none of the specimens was burned out; and there may be drips igniting the cotton placed below each specimen may.

**[Table 1]**

| | Water resistance test on housing | Air permeance test (sec/100 ml) | Water pressure resistance test (kPa) | Breakdown voltage test | Flammability test | Weight per unit area of porous PTFE membrane (g/m²) | Thickness of porous PTFE membrane (mm) |
|---|---|---|---|---|---|---|---|
| Example 1 | No entry of water observed | 5 | 100 | 3000 V | V-0 | 71 | 0.13 |
| Example 2 | No entry of water observed | 8 | 250 | 4500 V | V-0 | 164 | 0.30 |
| Comparative Example 1 | Entry of water observed | 2 | 7 | 500 V | V-2 | 4 | 0.01 |
| Comparative Example 2 | Entry of water observed | 15 | 5 | 200 V | V-0 | - | - |

Table 1 reveals that the porous PTFE membranes each had flame resistance and insulation. Also, it indicates that the breakdown voltage was increased when the porous PTFE membrane had a larger weight per unit area or a larger thickness.

### Industrial Applicability

Preferably, the ventilation member of the present invention is used for a vented housing to be used in a situation in which flame resistance, water resistance or insulation is required. For Example, the ventilation member of the present invention preferably is used for a terminal box for a solar cell.

## Claims

1. A ventilation member to be fixed to a housing so as to cover an opening of the housing, comprising:
a support body in which a through hole is formed; and
a gas permeable membrane that covers the through hole and allows a gas passing through the opening to permeate through the gas permeable membrane,
wherein the support body contains a polyphenylene ether resin or a polyphenylene oxide resin, and
the gas permeable membrane is composed only of a porous polytetrafluoroethylene membrane.

2. The ventilation member according to claim 1, wherein the gas permeable membrane is welded to a surface of the support body.

3. The ventilation member according to claim 1, wherein the support body has a fixing face to be fixed to the housing, and
a welding rib is disposed on the fixing face.

4. The ventilation member according to claim 1, wherein the support body has a fixing face to be fixed to the housing, and
the fixing face is composed of the polyphenylene ether resin or the polyphenylene oxide resin.

5. The ventilation member according to claim 1, wherein the support body is a flat plate.

6. The ventilation member according to claim 1, wherein the gas permeable membrane has a weight per unit, area of 20 g/m² or more.

7. The ventilation member according to claim 1, wherein the gas permeable membrane has a thickness of 0.1 mm to 0.5 mm.

8. The ventilation member according to claim 1, wherein a breakdown voltage of the gas permeable membrane is 2000 V or higher.

9. The ventilation member according to claim 1, wherein the gas permeable membrane has an air permeance of 40 seconds/100 ml or less in terms of Gurley number.

10. The ventilation member according to claim 1, wherein the gas permeable membrane has a water pressure resistance of 0.05 MPa or higher.

11. The ventilation member according to claim 1, wherein a plurality of the through holes are formed.

12. A vented housing comprising:
the ventilation member according to claim 1; and
a housing having an opening,
wherein the housing contains a polyphenylene ether resin or a polyphenylene oxide resin, and
the ventilation member is fixed to the housing so as to cover the opening.
